# EUROPEAN PATENT APPLICATION

(11) **EP 3 349 263 A1**
(43) Date of publication of application: **18.07.2018**
(21) Application number: 18151477.9
(22) Date of filing: 12.01.2018
(51) Int. Cl.: H01L 35/22, H01L 35/32, C01B 32/182

(54) **A THERMOELECTRIC CELL BASED ON A LAYERED TWO-DIMENSIONAL MATERIAL, PREFERABLY GRAPHENE, AND THE FABRICATION METHOD OF SUCH A THERMOELECTRIC CELL**

(30) Priority: 13.01.2017 PL 42017017
(71) Applicant: Inglot, Michal, 36-060 Glogow Malopolski (PL)
(72) Inventor: Inglot, Michal, 36-060 Glogow Malopolski (PL)
(74) Representative: AOMB Polska Sp. z.o.o.

(57) **Abstract**

The object of the invention is a thermoelectric cell comprising active layers of 2D material, preferably graphene or its derivative, arranged on a substrate (1) serving as an electrically and thermally insulating material in such a way, that the individual active layers of the 2D KT (2) are separated from each other by the material of the substrate (1), insulating electrically and thermally, and characterized by that is has an effectively close arrangement of windings created by the rolled, especially spirally, active layer of the 2D material (2), or the stack of x layers of the 2D material and the substrate (1), and the top and bottom collecting electrodes (5).

The object of the invention also a method of manufacturing such a thermoelectric cell.

## Description

The object of the present invention is a thermoelectric cell based on a layered two-dimensional (2D) material, preferably graphene, and the method of manufacturing such a thermoelectric cell.

An ideal graphene crystal consists of carbon atoms in a hexagonal pattern, which create an infinite single layer of atomic thickness. As many experiments have indicated, graphene possesses very desirable electron, electrical, mechanical, and chemical properties. One of the most important of those is the ability to conduct an electric current even at zero concentration of the electric charges. This is due to the interaction of electrons with the periodic potential of the hexagonal carbon lattice, which leads to the creation of new quasiparticles with close to zero effective mass. Another important feature of graphene is its high saturation current, which makes large current densities in graphene possible.

Aside from a very good electrical conductivity, a good thermal conductivity is also a characteristic of graphene. For that reason, graphene is an ideal material for applications in electronics, as one can obtain high powers from a unitary volume of elements. There exist many methods of graphene manufacturing, with some worth mentioning, such as: micromechanical cleavage, peeling off with an adhesive tape, chemical vapour deposition (CVD), reduction of graphite oxide by thermal decomposition, and subsequent reduction with hydrogen, or sublimation of silicon on SiC. All the production methods mentioned can be used to obtain graphene layers, which will then serve for construction of the thermoelectric cell.

The thermoelectric effect is widely used in thermoelectric cells based on semiconductor materials, currently most commonly used are Bi2Te3, Bi2Se3, Sb2Te3 (for low temperature applications), and alloys based on PbTe, CoSb3, SiGe, and skutterudite (for high temperature applications). The standard materials used until recently have been fabricated by crystallization from a liquid phase and hence possess a coarse-grained solid structure and high thermal conductivity.

The known thermoelectric cell (thermocouple) is an element of an electric circuit which usually consists of two different materials, each with a different electron work function. Typically it is a joint of two different metals or semiconductors. By applying a temperature T₁ to one side of the joint, and a temperature T₂ to the other, and whilst maintaining this temperature difference, e.g. T there is a flow of electric current in the circuit due to the Seebeck effect. The Seebeck effect is the operating foundation of thermoelectric elements, describing how a charge current arises from the existence of a temperature gradient. The thermoelectric elements are characterised by a series of parameters, such as the Seebeck coefficient α, thermal conductivity κ, and electric conductivity σ or a dimensionless parameter that characterizes the merit (ZT) of thermoelectric system.

The object of the present invention is a new thermoelectric cell and its method of manufacturing. This cell generates an electric current for a non-zero temperature gradient, independent of the ambient temperature, by using a 2D material - preferentially graphene or its derivatives - based on a thermoelectric process. The thermoelectric effect is the phenomenon whereby there is a direct transformation of an electric voltage existing between two points of a system into a temperature difference between those points, or vice-versa - a transformation of a temperature difference into an electric voltage. It is used for heating, cooling, temperature measurement, and generation of a potential difference. In general, the thermoelectric effect can occur for a composite of two different materials (marked below as A and B) - one with an electron deficiency, and the other with an electron abundance, and while both material have different temperatures (with a temperature gradient, ∇T, between them). It results in the flow of electron, generating an electric current j. The generation of electric current due to a temperature difference is connected with the Seebeck effect. In ideal conditions the magnitude of the created voltage (V) is directly proportional to both the temperature difference (TA≠TB) between the materials, and also to the difference of the Seebeck coefficients (αA, αB) of material A and material B, (α - thermoelectric coefficient for a given material).

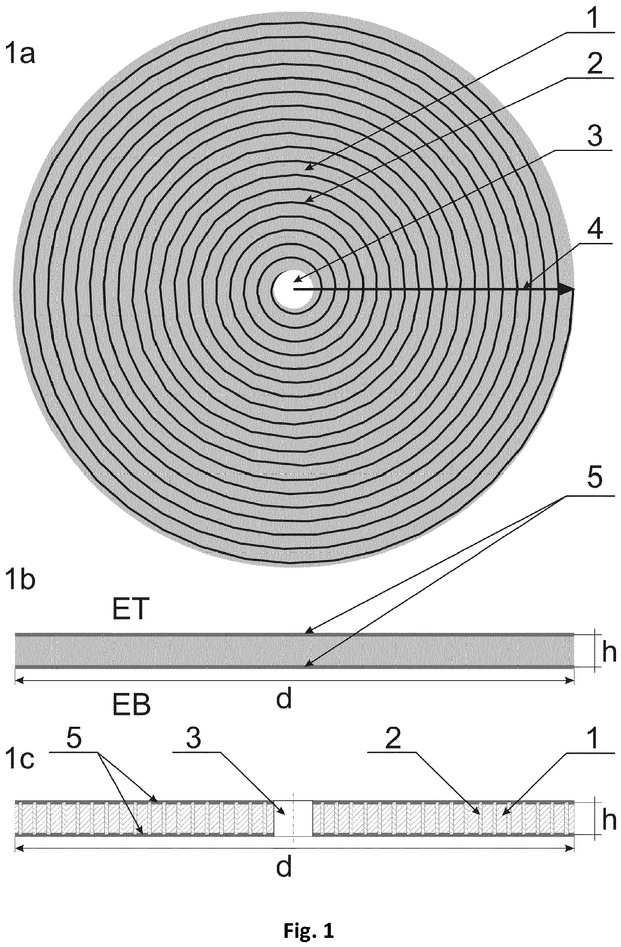

In the case of this proposed thermoelectric cell the crucial element, except for the graphene itself, is the substrate, which plays a threefold role: it is a separator for the current flow between the layers of the thermoelectric converter (KT) made from the 2D material, preferably graphene, it serves as a construction material on which all the manufacturing processes can be executed, and it is an isolating layer which thermally isolates the electrode ET from the electrode EB. The effective temperature gradient is oriented as parallel to the plane KT of graphene aligned on the substrate, which is rolled up to create, for example, an Archimedean spiral, Fig. 1. Such a device induces a non-zero electric current, j, when different temperatures appear in the top (electrode ET) and the bottom (electrode EB) part of the cell. The indicated orientation of graphene on the substrate presented on Fig. 1a is characterised by a non-zero number of windings arranged effectively close to each other so that a length of n meters of rolled KT, preferably graphene 2 on substrate 1 is present per unit of area. The substrate 1 can be made of any chosen dielectric material that serves as a means for transport, electrical and thermal insulation of the layer KT. The minimal thickness of the support is set such that it must provide a proper execution of the manufacturing processes, and provide a proper insulation against the flow of the shortage current or against quantum mechanical tunnelling between the layers of converter 2. Scaling of the cell can be achieved either by increasing the number of the windings, or the number of graphene layers on the substrate (multiple layers of graphene), which leads to an increase in the generated current j. Therefore, a thermoelectric cell based on graphene has an enormous advantage over typical thermoelectric cells based on a bulk materials.

In the sense of the present application the term 'graphene and its 0D and 1D derivatives' includes also multilayered graphene, i.e. structure with x layers of graphene stacked one above another at a distance of 0.2nm or more.

Moreover it is acknowledged that alternatively, instead of utilizing a 2D material, i.e. graphene, on a thermally and electrically insulating substrate, one can use a stack of fragments of a graphene-substrate material or buffer layer, e.g. 10⁶ of such layers. The layers in the stack are principally oriented parallel with respect to each other. More precisely, the 2D material, especially graphene, is placed on an elastic substrate, and the graphene has one or multiple layers separated from each other with a buffer, which contains dopants such as quantum dots etc. (between individual layers of graphene) and other molecular structures. The goal is to obtain the most favorable ratio of graphene to the thickness of the substrate.

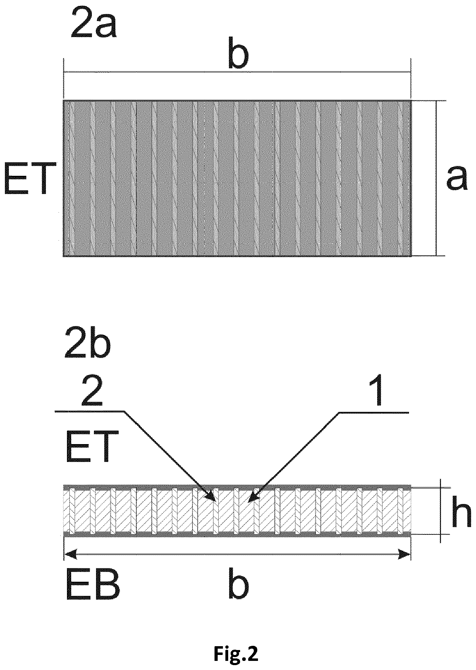

An example of a stack presented in figures 2a and 2b does not put any restraint neither on the quantities a, b, and h, which the current-voltage parameters depend on, nor on the number of side walls, which determine the desired geometry of the thermoelectric cell. The top and bottom electrodes, ET and EB respectively, are in principle oriented perpendicularly to the plane of the windings and stacks.

The of the present invention is a device capable of converting thermal energy into electrical energy based on a 2D material, preferably graphene, and its' manufacturing method. The converter of the thermal energy into the electric energy can be graphene in a pure form, understood as one-, two-, triple- or multilayered graphene, doped with elements from the groups I to 17 of the periodic table, composites with a chemical composition CₓXₓ are also possible. Although pure graphene is already sufficient, doping such a layer with atoms, molecules, 0D objects (quantum dots) etc. adds resonant states or additional charges into the converter, increases efficiency of the thermoelectric system. Graphene is a two dimensional hexagonal lattice of atoms, possessing two inequivalent Dirac points in the Brillouin zone. The thermoelectric cell will consist of three main parts, that is an active layer (AL, Figure 1, Figure 2 (2)) (any 2D material, graphene in a form of continuous defected or undefected layer, 1D graphene strips, or 0D graphene quantum dots), a substrate and/or buffer layer (P, Figure 1, Figure 2 (1)); and top and bottom electrodes (ET, EB, Figure 1b (5)). Also in this case the 2D material, preferably graphene, is placed on an elastic substrate, and this graphene has single or many layers separated from each other with a buffer, which contains dopants such as quantum dots etc. (between each graphene sheet) and other molecular structures. The goal is to obtain the most favorable ratio of graphene to the thickness of the substrate.

The thermoelectric cell comprising active layers of a 2D material, preferably graphene or its derivative, placed on a substrate acting as an electrically and thermally insulating material in such a way, that individual active layers of the KT material are separated from each other by the substrate material that insulates electrically and thermally, according to the invention is characterized by the fact that it has closely arranged windings created by the rolled, especially spirally, active layer of the 2D material or of a stack of x layers of the 2D material and the substrate, and the top and bottom collecting electrodes.

Preferably, the top and bottom collecting electrodes, are aligned perpendicularly to the plane of the substrate in the roll or in the stack.

Preferably, the collecting electrodes are made from a conductive material with a surface resistance not greater than 10Ω/sq.

Preferably, the substrate is fabricated from a PET poly(ethylene terephthalate) or PMMA poly(methyl methacrylate) material, or from a high temperature silicon, or from other thermo-resistive polymer, or from layers obtained using ALD or PVD techniques.

Preferably, the material of the substrate has a relatively small weight and allows for working temperatures in a range from minus 80°C to 600°C, or preferably from minus 200°C to 1500°C .

Preferably, the thickness of the substrate is in the range of 10nm to 3mm.

The invention also comprises a manufacturing method of a thermoelectric cell based on a two dimensional 2D material having layered structure, preferably graphene or its derivative, with active layers of which are placed on a substrate of an electrically and thermally insulating material, optionally elastic, in such a way that individual active layers of the KT material are separated from each other by the substrate, and that wherein the cell possesses closely arranged windings created by the rolled, especially spirally, active layer of the 2D materialor a stack of x layers of the 2D material and the substrate, and a top and a bottom collecting electrodes, the manufacturing process comprises the following steps:
a. at least one layer of the two dimensional 2D layered structure material, preferentially graphene or its derivative, is deposited onto an elastic, thermally and electronically insulating substrate, of a thickness from 10nm to 3mm;
b. on the deposited layer of the two dimensional material one can optionally deposit the collecting electrodes with a thickness from 10nm to 10µm, where the collecting electrodes tightly abut the graphene material;
c. the strips of the two dimensional 2D material are rolled on the substrate (1), optionally elastic, preferably on a core, especially of a diameter from 0,001mm to 3mm, or the layers of the two dimensional 2D material are arranged on a substrate, optionally elastic, into a stack;
d. on the upper and lower bases of the roll or stack obtained in step c), respectively, conducting layers are deposited which form collecting electrodes, preferably of a thickness no greater than 1mm;
e. the roll or the stack is placed in a material protecting and insulating from the influence of the external environment (packaging).

Preferably, in the steps b) and d), the collecting electrodes are deposited to extend perpendicularly to the plane of the substrate in the roll or the stack.

Preferably, for the material of the substrate with electrically and thermally insulating properties, a PET poly(ethylene terephthalate) or PMMA poly(methyl methacrylate) foil is used, or high temperature silicons, or other thermo-resistive polymers.

Preferably, the film of the active two dimensional 2D material with layered structure, preferably graphene or its derivative, is deposited using the CVD technique.

Preferably, collecting electrodes are used, the electric resistivity of which is below the value of 10Ω/sq.

Preferably, the collecting electrodes function in the temperature range from minus 80°C up to 600°C, or even from minus 200°C up to 1500°C.

Preferably, in steps b) and/or d), the collecting electrodes are deposited using the PVD or ALD technique.

More precisely, with respect to graphene, the manner of manufacturing the thermoelectric converter ( the graphene film of a given number of single graphene layers) consist in:
1) manufacturing of graphene deposited on a copper foil using the CVD technique;
2) transfer of the graphene film from the copper substrate onto another substrate, which is a different polymer foil, a metallic foil, or a rigid insulating, conducting or semiconducting substrate; using either electrochemical delamination or by etching of the Cu substrate
3) removing the PMMA using a solvent (preferably acetone),
4) repeating steps 1, 2, and 3 until the appropriate number of graphene layers is obtained.

In such a case:
- Preferably, the graphene film is synthesised on a copper substrate using the chemical vapour deposition (CVD) technique,
- Preferably, the substrate for the graphene deposition is a copper foil with different thickness, whereas the substrate can be manufactured from another material, e.g.: nickel, platinum, gold, silver, iridium, germanium, or their alloys.
- Preferably, the polymer substrate is poly(methyl methacrylate), although it could also be another polymer soluble or insoluble in water.
- Preferably, before the step of the polymer deposition on the graphene/copper stack, the quality of the graphene film on copper substrate is evaluated by performing Raman spectroscopy measurements or another technique, which would allow for the detection of the graphene film.

### Preferable embodiments of the invention

The invention will now be presented in more detail in preferred embodiments with reference to the included drawings, in which:
Figure 1a. presents view from above of a graphene thermoelectric cell in a cylindrical geometry,
Figure 1b. presents the side view of a graphene thermoelectric cell in a cylindrical geometry, whereas
Figure 1c presents the sectional view of a graphene thermoelectric cell in a cylindrical geometry, whereas
Figure 2a. presents the top view of a graphene thermoelectric cell in a hexagonal geometry.
Figure 2b. presents a sectional view of a graphene thermoelectric cell in a hexagonal geometry is shown.

In the description of the invention the following labels were used:
1 - substrate providing electrically and thermally insulating material (P);
2 - active layer (AL) - 2D converter, preferably a layer of graphene;
3 - core of the cell (C);
4 - radius of the cell (R);
5 - top (ET) and bottom (EB) collecting electrodes.

### Example 1-Thermoelectric cell according to the invention

Figure 1a shows a selected embodiment of the invention - the technological solution for a thermoelectric cell based on graphene, a 2D material. 2D graphene (or its 0D and 1D derivatives) is a two dimensional lattice of carbon atoms, marked in black, exhibiting a hexagonal structure. Within this application "2D graphene or its 0D and 1D derivatives" refers also to multilayered graphene, i.e. a structure, in which x layers of graphene are arranged one above another at a distance 0.2nm or greater. Individual layers of graphene are separated from each other using a thermally and electrically insulating material 1, for example PET poly(ethylene terephthalate), or PMMA poly(methyl methacrylate), or other polymer. The minimal thickness of the insulating layer is determined by the possible occurring of tunnel currents between the individual graphene layers, and it is dependent on the chemical composition of the substrate. In general it can be assumed, that the lower limit of the thickness to be 10nm and for 3mm to be the maximal thickness. The important parameter in the case of the geometry presented in figure 1a is the effective length of the substrate within the graphene spiral, which should be larger than 1cm for the thermoelectric cell, while the maximal length is limited only by the aspect of the application (the size of the cell and its current-voltage parameters will depend on the length of the strip), in general the longer the strip, the larger the energy gain. Figure 1a shows the top view of a thermoelectric cell without taking into account the collecting electrodes 5. The top electrode (ET) and the bottom electrode (EB) are manufactured from a conductive material (either metal, or a conducting polymer, or another good conducting material) with surface resistance no greater than 10 Ω/sq. The height h of graphene determines the current-voltage parameters of the thermoelectric effect while preserving temperature difference existing at ET and EB, i.e. TT>TB. The temperature gradient VT=TT-TB is expressed in kelvins per meter K/m, which means that while decreasing the distance h between the top and the bottom electrode, one increases VT. The thermoelectric current induced in graphene is proportional to the temperature gradient ∇T, therefore for the nonzero temperature difference VT between the top and bottom surface of the thermocouple an electric current will be induced.

Another selected geometry of the cell according to the present invention is presented in figures 2a and 2b. A construction of an arbitrary geometry, preferably cubic, is of two separated surfaces (layers) KT (2) manufactured from a 2D material, an electrically and thermally insulating substrate layer (1), which can be manufactured from a PET poly(ethylene terephthalate), a PMMA poly(methyl methacrylate) material, or from a high temperature silicon, or from other thermo-resistive polymer, or from layers using ALD or PVD techniques. A thermoelectric cell manufactured in a cubic geometry possesses a top (ET) and a bottom (EB) electrode, which are oriented approximately perpendicular to the KT layer (2) and to the substrate (P). The collecting electrodes 5 (ET and EB) are manufactured from a conductive material (a metal, or a conducting polymer, or another good conductive material) with surface resistance not greater than 10 Ω/sq.

Within this application "2D graphene or its 0D and 1D derivatives" also includes multilayered graphene, i.e. a structure, in which x layers of graphene are arranged one above another at a distance 0.2nm or greater.

The remaining elements of the cell are built similarly to the example given above.

### Example 2 - manufacturing method of the graphene based thermoelectric cell.

The manufacturing process of the system, based on a layered two dimensional 2D material, which converts thermal energy into electrical energy, which constitutes the thermoelectric cell from Example 1, is executed in the following stages:
a. A graphene layer (or x layers of graphene separated from each other with a buffer in the form of technological residues or controlled inclusions in the form of quantum dots, adatoms, molecular systems, etc.) is located on an elastic insulating substrate.
b. The electric contacts at the edges of the graphene strips previously deposited on the substrate are deposited; an elastic substrate can be utilized, or a rigid substrate, the latter one - for example in the case of a cubic geometry.
c. Winding of the graphene strips on the elastic substrate occurs, preferably on a core, especially with a diameter of 0,001mm to 3 mm.
d. Consecutively on the top and bottom surface a conductive layer (electrode) is deposited, preferably with a thickness not larger than 1mm.
e. The spiral is placed in a protective material which insulates it from the influence of the external environment (packaging).

## Claims

1. A thermoelectric cell comprising active layers of a 2D material, preferably graphene or its derivative, arranged on a substrate (1) made of an electrically and thermally insulating material in such a way, that individual active layers of the 2D material KT (2) are separated from each other by the electrically and thermally insulating substrate material (1),. **characterized in that** it comprises effectively close arrangement of the windings created by rolled, especially spirally, active layer of the 2D material (2) or the stack of x layers of the 2D material and the substrate (1), and a top a bottom collecting electrodes (5).

2. The thermoelectric cell according to the claim 1, **characterized in that** the top and the bottom collecting electrodes (5) are perpendicular to the substrate plane (1) in the roll or the stack.

3. The thermoelectric cell according to the claim 1 or 2, **characterized in that** the collecting electrodes (5) are manufactured from a conductive material with a surface resistance not greater than 10 Ω/sq.

4. The thermoelectric cell according to the claim 1, 2, or 3, **characterized in that** the substrate (1) is manufactured from PET poly(ethylene terephthalate) or from PMMA poly(methyl methacrylate), or from a high temperature silicon, or from another thermo-resistive polymer, or from layers obtained using ALD or PVD techniques.

5. The thermoelectric cell according to any one of the claims 1-4, **characterized in that** the material of the substrate (1) is of a small weight and allows for work in temperature conditions ranging from minus 80°C to 600°C, or preferably from minus 200°C to 1500°C.

6. The thermoelectric cell according to any one of the claims 1-5, **characterized in that** the thickness of the substrate (1) is between 10nm and 3mm.

7. A method of manufacturing of a thermoelectric cell based on a two dimensional 2D material (2) exhibiting a layered structure, preferably graphene or its derivative, in which the active layers are located on an electrically and thermally insulating, optionally elastic, substrate (1) in such a way, that the individual active layers of the KT material (2) are separated from each other by this substrate (1) and wherein the cell possesses an effectively close arrangement of the windings created by the rolled, especially spirally, active layer or the stack of x layers of the 2D material and the substrate (1), and a top and a bottom collecting electrodes (5), said method comprising the following steps:
a. at least one layer of the two dimensional material (2), which is preferably graphene or one of its derivatives, is deposited on a thermally and electrically insulating elastic substrate (1) with a thickness from 10nm to 3mm;
b. optionally, on the deposited layer of the two dimensional material (2), the collecting electrodes (5) are deposited with a thickness of 10nm to 10µm, with the electrodes (5) being tightly adjacent to the graphene material (2);
c. the winding of the strips of the two dimensional material (2) on the possibly elastic substrate is carried out, preferably on a core, especially with a diameter of 0,001mm to 3mm, or alternatively piling the two dimensional 2D material on a substrate (1), possibly elastic, into a stack;
d. on the top and bottom surface of the roll or stack obtained in step c) respectively a conductive layer is deposited forming the collecting electrodes (5), preferably with a thickness not larger than 1mm.
e. the roll or the stack is placed in a protective material, insulating it from the influence of the external environment (packaging).

8. The method according to claim 7, **characterized in that** in step b) and/or step d) the collecting electrodes (5) are deposited to extend perpendicular to the substrate plane (1) in the roll or stack.

9. The method according to claim 7 or 8, **characterized in that** for the material of the substrate (1) with the thermally and electrically insulating properties a foil of PET poly(ethylene terephthalate) or of PMMA poly(methyl methacrylate), or a high temperature silicon, or other thermo-resistive polymer is used.

10. The method according to the claim 7, 8, or 9, **characterized in that** the active layer (2) of the two dimensional 2D material with a layered structure, preferably graphene or its derivatives, is deposited using the CVD technique.

11. The method according to any one of the claims 7 to 10, **characterized in that** collecting electrodes (5) are used with an electrical resistance below the value of 10Ω/sq.

12. The method according to any one of the claims 7 to 11, **characterized in that** the collecting electrodes (5) function in the temperature range from minus 80°C up to 600°C, or preferably from minus 200°C up to 1500°C.

13. The method according to any one of the claims 7 to 12, **characterized in that** in step b) and/or d) the collecting electrodes (5) are deposited using the PVD or ALD technique.
